# EUROPÄISCHE PATENTANMELDUNG

(11) **EP 2 819 285 A1**
(43) Veröffentlichungstag der Anmeldung: **31.12.2014**
(21) Anmeldenummer: 14165371.7
(22) Anmeldetag: 22.04.2014
(51) Int. Cl.: H02M 1/088, H03K 17/08, H03K 17/12

(54) **Leistungshalbleiterschaltung**

(30) Priorität: 28.06.2013 DE 102013106801
(71) Anmelder: SEMIKRON Elektronik GmbH & Co. KG, 90431 Nürnberg (DE)
(72) Erfinder: Kobolla, Harald, 90556 Seukendorf (DE); Königsmann, Gunter, 91094 Langensendelbach (DE); do Nascimento-Singer, Jair, 91077 Dormitz (DE); Katzenberger, Günter, 97084 Würzburg (DE)

(57) **Zusammenfassung**

Die Erfindung betrifft eine Leistungshalbleiterschaltung aufweisend,
• mehrere elektrisch parallel geschaltete Leistungshalbleiterschalter, wobei die Leistungshalbleiterschaltung derart ausgebildet ist, dass bei einem einzelnen der Leistungshalbleiterschalter eine zwischen dem ersten und zweiten Laststromanschluss auftretende elektrische Leistungshalbleiterschalterspannung des betreffenden Leistungshalbleiterschalters überwacht wird und
• eine Ansteuereinheit, die zur Erzeugung eines Ansteuersignals zur Ansteuerung der Leistungshalbleiterschalter ausgebildet ist, wobei die Ansteuereinheit mit den Steueranschlüssen der Leistungshalbleiterschalter und mit den zweiten Laststromanschlüssen der Leistungshalbleiterschalter elektrisch verbunden ist,
wobei elektrisch zwischen den Leistungshalbleiterschaltern, deren Leistungshalbleiterschalterspannung nicht überwacht wird und der Ansteuereinheit, jeweilig eine Gleichtaktdrossel geschaltet ist, und elektrisch zwischen dem Leistungshalbleiterschalter, dessen Leistungshalbleiterschalterspannung überwacht wird und der Ansteuereinheit keine Gleichtaktdrossel geschaltet ist.

Die Erfindung schafft eine Leistungshalbleiterschaltung, bei der eine möglichst gleichmäßige Stromaufteilung zwischen den elektrisch parallel geschalteten Leistungshalbleiterschaltern der Leistungshalbleiterschaltung und eine zuverlässige Überwachung einer zwischen dem ersten und zweiten Laststromanschluss auftretenden elektrischen Leistungshalbleiterschalterspannung bei einem der elektrisch parallel geschalteten Leistungshalbleiterschalter erzielt wird.

## Beschreibung

Die Erfindung betrifft eine Leistungshalbleiterschaltung.

Bei aus dem Stand der Technik bekannten Leistungshalbleitereinrichtungen sind im Allgemeinen auf einem Substrat Leistungshalbleiterbauelemente, wie z.B. Leistungshalbleiterschalter und Dioden angeordnet und mittels einer Leiterschicht des Substrats, sowie Bonddrähten und/oder einem Folienverbund miteinander elektrisch leitend verbunden. Die Leistungshalbleiterschalter liegen dabei im Allgemeinen in Form von Transistoren, wie z.B. IGBTs (Insulated Gate Bipolar Transistor) oder MOSFETs (Metal Oxide Semiconductor Field Effect Transistor) vor.

Die auf dem Substrat angeordneten Leistungshalbleiterbauelemente sind dabei häufig elektrisch zu einer einzelnen oder mehreren sogenannten Halbbrückenschaltungen verschalten, die z.B. zum Gleich- und Wechselrichten von elektrischen Spannungen und Strömen verwendet werden.

Bei hohen Lastströmen ist es dabei oft erforderlich, wenn die Stromtragefähigkeit eines einzelnen Leistungshalbleiterschalters nicht ausreichend ist, mehrere Leistungshalbleiterschalter elektrisch parallel zu schalten und diese gemeinsam anzusteuern, so dass diese zusammen einen Hochleistungshalbleiterschalter bilden. Dabei sollen möglichst alle parallel geschalteten Leistungshalbleiterschalter zeitsynchron ein- und ausschalten um eine gleichmäßige Stromaufteilung auf die elektrisch parallel geschalteten Leistungshalbleiterschalter zu erzielen.

Nachteilig bei einem solchen Aufbau ist, dass, z.B. aufgrund von Bauteiltoleranzen und unterschiedlicher parasitärer Induktivitäten der Zuleitungen zu den elektrisch parallel geschalteten Leistungshalbleiterschaltern, es zu unterschiedlichen Ein- und Ausschaltzeitpunkten der elektrisch parallel geschalteten Leistungshalbleiterschalter kommt. Die unterschiedlichen Ein- und Ausschaltzeitpunkte führen zu elektrischen Potentialverschiebungen an den Emittern der elektrisch parallel geschalteten Leistungshalbleiterschaltern, so dass sich die elektrisch parallel geschalteten Leistungshalbleiterschalter gegenseitig in Ihrem Schaltverhalten beeinflussen, was zu einer ungleichmäßigen Stromaufteilung zwischen den elektrisch parallel geschalteten Leistungshalbleiterschaltern führt.

Zur Lösung dieser Problematik ist es aus der EP 1625 660 B1 bekannt bei allen elektrisch parallel geschalteten Leistungshalbleiterschaltern zwischen der Ansteuereinheit, welche die elektrisch parallel geschalteten Leistungshalbleiterschalter ansteuert und den elektrisch parallel geschalteten Leistungshalbleiterschaltern jeweilig eine Gleichtaktdrossel vorzusehen, die in der EP 1625 660 B1 als Gleichtaktunterdrückungsdrossel bezeichnet wird.

Zur Erkennung von Überströmen, welche zu einer Zerstörung oder Beschädigung der elektrisch parallel geschalteten Leistungshalbleiterschalter führen können, ist es wünschenswert eine sehr schnell arbeitende Überstromüberwachung vorzusehen. Techniküblich wird hierzu an einem einzelnen der elektrisch parallel geschalteten Leistungshalbleiterschalter die zwischen Kollektor und Emitter des betreffenden Leistungshalbleiterschalters auftretende Leistungshalbleiterschalterspannung überwacht und wenn diese im eingeschalteten Zustand des betreffenden Leistungshalbleiterschalters einen Grenzwert überschreitet eine Abschaltung aller elektrisch parallel geschalteten Leistungshalbleiterschalter veranlasst.

Nachteilig bei der in der EP 1625 660 B1 vorgeschlagen Lösung ist, dass die oben beschriebene Überstromüberwachung nicht mehr ordnungsgemäß funktioniert, da eine am Emitter des Leistungshalbleiterschalters, dessen Leistungshalbleiterschalterspannung für die Überstromüberwachung überwacht wird, auftretende elektrische Potentialverschiebung zu einer nicht unerheblichen elektrischen Spannung an der elektrisch zwischen der Ansteuereinheit und dem Emitter des Leistungshalbleiterschalters geschalten zweiten Wicklung der betreffenden Gleichtaktdrossel führt, was der Überstromüberwachung eine scheinbar zu hohe Leistungshalbleiterschalterspannung des betreffenden Leistungshalbleiterschalters vortäuscht und somit einen Überstrom vortäuscht.

Es ist Aufgabe der Erfindung eine Leistungshalbleiterschaltung zu schaffen, bei der eine möglichst gleichmäßige Stromaufteilung zwischen den elektrisch parallel geschalteten Leistungshalbleiterschaltern der Leistungshalbleiterschaltung und eine zuverlässige Überwachung einer zwischen dem ersten und zweiten Laststromanschluss auftretenden elektrischen Leistungshalbleiterschalterspannung bei einem der elektrisch parallel geschalteten Leistungshalbleiterschalter erzielt wird.

Diese Aufgabe wird gelöst durch eine Leistungshalbleiterschaltung aufweisend,
- mehrere elektrisch parallel geschaltete Leistungshalbleiterschalter, die jeweilig einen ersten und einen zweiten Laststromanschluss und einen Steueranschluss aufweisen, wobei die ersten Laststromanschlüsse der Leistungshalbleiterschalter elektrisch leitend miteinander verbunden sind und die zweiten Laststromanschlüsse der Leistungshalbleiterschalter elektrisch leitend miteinander verbunden sind, wobei die Leistungshalbleiterschaltung derart ausgebildet ist, dass bei einem einzelnen der Leistungshalbleiterschalter eine zwischen dem ersten und zweiten Laststromanschluss auftretende elektrische Leistungshalbleiterschalterspannung des betreffenden Leistungshalbleiterschalters überwacht wird und
- eine Ansteuereinheit, die zur Erzeugung eines Ansteuersignals zur Ansteuerung der Leistungshalbleiterschalter ausgebildet ist, wobei die Ansteuereinheit mit den Steueranschlüssen der Leistungshalbleiterschalter und mit den zweiten Laststromanschlüssen der Leistungshalbleiterschalter elektrisch verbunden ist,
   wobei elektrisch zwischen den Leistungshalbleiterschaltern, deren Leistungshalbleiterschalterspannung nicht überwacht wird und der Ansteuereinheit jeweilig eine Gleichtaktdrossel geschaltet ist oder falls die Leistungshalbleiterschaltung nur zwei Leistungshalbleiterschalter aufweist, elektrisch zwischen dem Leistungshalbleiterschalter, dessen Leistungshalbleiterschalterspannung nicht überwacht wird und der Ansteuereinheit, eine Gleichtaktdrossel geschaltet ist,
   wobei elektrisch zwischen dem Leistungshalbleiterschalter, dessen Leistungshalbleiterschalterspannung überwacht wird und der Ansteuereinheit keine Gleichtaktdrossel geschaltet ist,
   wobei die jeweilige Gleichtaktdrossel eine erste Wicklung und eine mit der ersten Wicklung magnetisch gekoppelte zweite Wicklung aufweist, wobei die erste Wicklung elektrisch zwischen der Ansteuereinheit und dem Steueranschluss des jeweiligen Leistungshalbleiterschalters geschaltet ist und die zweite Wicklung elektrisch zwischen der Ansteuereinheit und dem zweiten Lastanschluss des jeweiligen Leistungshalbleiterschalters geschaltet ist.

Vorteilhafte Ausbildungen der Erfindung ergeben sich aus den abhängigen Ansprüchen.

Es erweist sich als vorteilhaft, wenn elektrisch zwischen der Ansteuereinheit und dem Steueranschluss des Leistungshalbleiterschalters, dessen Leistungshalbleiterschalterspannung überwacht wird, eine diskrete Spule geschaltet ist oder ein magnetisch leitendes Element umlaufend um eine elektrisch zwischen der Ansteuereinheit und dem Steueranschluss des Leistungshalbleiterschalters, dessen Leistungshalbleiterschalterspannung überwacht wird, geschaltete Leitung angeordnet ist. Hierdurch kann das Schaltverhalten des Leistungshalbleiterschalters, dessen Leistungshalbleiterschalterspannung überwacht wird, an das Schaltverhalten der übrigen elektrisch parallel geschalteten Leistungshalbleiterschalter angepasst werden.

Weiterhin erweist es sich als vorteilhaft, wenn elektrisch zwischen der Ansteuereinheit und dem zweiten Lastanschluss des Leistungshalbleiterschalters, dessen Leistungshalbleiterschalterspannung überwacht wird, eine diskrete Spule geschaltet ist oder ein magnetisch leitendes Element umlaufend um eine elektrisch zwischen der Ansteuereinheit und dem zweiten Laststromanschluss des Leistungshalbleiterschalters, dessen Leistungshalbleiterschalterspannung überwacht wird, geschaltete Leitung angeordnet ist. Hierdurch kann das Schaltverhalten des Leistungshalbleiterschalters, dessen Leistungshalbleiterschalterspannung überwacht wird, an das Schaltverhalten der übrigen elektrisch parallel geschalteten Leistungshalbleiterschalter angepasst werden.

Weiterhin erweist es sich als vorteilhaft, wenn das magnetisch leitende Element als Ferritperle oder als Klappferrit ausgebildet ist, da dies übliche Ausbildungen eines magnetisch leitenden Elements darstellen.

Weiterhin erweist es sich als vorteilhaft, wenn die Leistungshalbleiterschaltung derart ausgebildet ist, dass falls im eingeschalteten Zustand des Leistungshalbleiterschalters dessen Leistungshalbleiterschalterspannung überwacht wird, die Leistungshalbleiterschalterspannung einen Grenzwert überschreitet, eine Ausschaltung aller elektrisch parallel geschalteten Leistungshalbleiterschalter durchgeführt wird. Hierdurch wird eine zuverlässige und sehr schnell arbeitende Überstromüberwachung der elektrisch parallel geschalteten Leistungshalbleiterschalter erreicht.

Ausführungsbeispiele der Erfindung sind in den Figuren dargestellt und werden im Folgenden näher erläutert. Dabei zeigen:
- FIG 1: eine Leistungshalbleitereinrichtung,
- FIG 2: eine erfindungsgemäße Leistungshalbleiterschaltung und
- FIG 3: eine weitere Ausbildung einer erfindungsgemäßen Leistungshalbleiterschaltung.

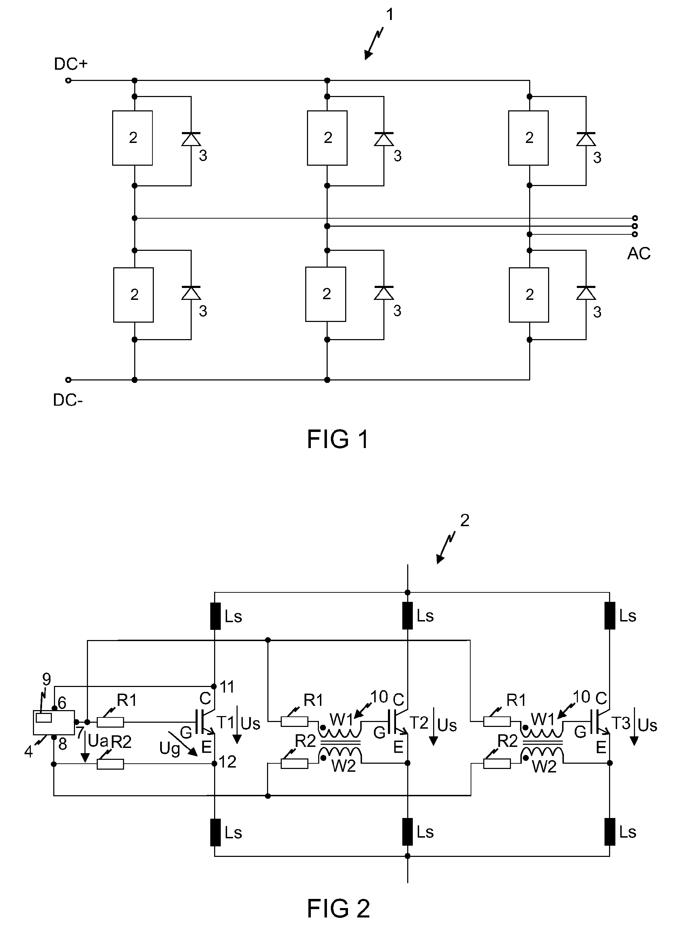

In FIG 1 ist eine Leistungshalbleitereinrichtung 1 dargestellt, die beispielhaft in Form einer sogenannten 3-phasigen Brückenschaltung ausgebildet ist. Die Leistungshalbleitereinrichtung 1 weist im Rahmen des Ausführungsbeispiels sechs erfindungsgemäße Leistungshalbleiterschaltungen 2 auf. In FIG 2 ist eine erfindungsgemäße Leistungshalbleiterschaltung 2 im Detail dargestellt. Den Leistungshalbleiterschaltungen 2 sind beim Ausführungsbeispiel jeweilig eine Freilaufdiode 3 elektrisch antiparallel geschaltet, wobei zu jeder Leistungshalbleiterschaltung 2 auch mehrere Freilaufdioden elektrisch antiparallel geschaltet sein können. Im Rahmen des dargestellten Ausführungsbeispiels erzeugt die Leistungshalbleitereinrichtung 1 aus einer linksseitig zwischen den Gleichspannungsanschlüssen DC+ und DC- eingespeisten Gleichspannung am Wechselspannungsanschluss AC eine 3-phasige Wechselspannung.

Die Leistungshalbleiterschaltung 2 weist mehrere elektrisch parallel geschaltete Leistungshalbleiterschalter T1, T2 und T3 auf, die jeweilig einen ersten Laststromanschluss C, einen zweiten Laststromanschluss E und einen Steueranschluss G aufweisen, wobei die ersten Laststromanschlüsse C der Leistungshalbleiterschalter T1, T2 und T3 elektrisch leitend miteinander verbunden sind und die zweiten Laststromanschlüsse E der Leistungshalbleiterschalter T1, T2 und T3 elektrisch leitend miteinander verbunden sind. Die elektrischen Zuleitungen zu den Leistungshalbleiterschaltern T1,T2 und T3 weisen dabei parasitäre Induktivitäten Ls auf. Es sei angemerkt, dass die erfindungsgemäße Leistungshalbleiterschaltung mindestens zwei elektrisch parallel geschaltete Leistungshalbleiterschalter aufweist und selbstverständlich noch mehr wie die drei im Ausführungsbeispiel elektrisch parallel geschalteten Leistungshalbleiterschalter T1, T2 und T3 aufweisen kann. Im Rahmen des Ausführungsbeispiels liegt der erste Laststromanschluss C in Form des Kollektors des jeweiligen Leistungshalbleiterschalters und der zweite Laststromanschluss E in Form des Emitters des jeweiligen Leistungshalbleiterschalters und der Steueranschluss G in Form des Gate des jeweiligen Leistungshalbleiterschalters vor. Die elektrisch parallel geschalteten Leistungshalbleiterschalter liegen vorzugsweise in Form von Transistoren, wie z.B. IGBTs (Insulated Gate Bipolar Transistor) oder MOSFETs (Metal Oxide Semiconductor Field Effect Transistor), wobei im Rahmen des Ausführungsbeispiels die Leistungshalbleiterschalter T1, T2 und T3 in Form von IGBTs vorliegen.

Weiterhin weist die Leistungshalbleiterschaltung 2 eine Ansteuereinheit 4 auf, die zur Erzeugung eines Ansteuersignals zur Ansteuerung der Leistungshalbleiterschalter T1, T2 und T3 ausgebildet ist, wobei die Ansteuereinheit 4 mit den Steueranschlüssen G der Leistungshalbleiterschalter T1, T2 und T3 und mit den zweiten Laststromanschlüssen E der Leistungshalbleiterschalter T1, T2 und T3 elektrisch verbunden ist. Die Ansteuereinheit 4 liegt in Form einer entsprechend ausgebildeten Ansteuerschaltung vor, wobei die Ansteuerschaltung einen einzelnen oder mehrere integrierte Schaltkreise aufweisen kann.

Die Ansteuereinheit 4 erzeugt das Ansteuersignal zur Ansteuerung der elektrisch parallel geschalteten Leistungshalbleiterschalter, indem sie an ihrem Anschluss 7 bezogen auf Ihren Anschluss 8 und somit gegenüber dem zweiten Laststromanschluss E der Leistungshalbleiterschalter eine positive oder negative Ausgangspannung Ua erzeugt. Wenn die Leistungshalbleiterschalters T1, T2 und T3 eingeschaltet werden sollen, wird von der Ansteuerschaltung 4 eine positive Ausgangsspannung Ua erzeugt und über den jeweiligen ersten elektrischen Widerstand R1 zum Steueranschluss G des jeweiligen Leistungshalbleiterschalters geführt. Wenn die Leistungshalbleiterschalter T1, T2 und T3 ausgeschaltet werden sollen, wird von der Ansteuerschaltung 4 eine negative Ausgangsspannung Ua erzeugt und über den jeweiligen ersten elektrischen Widerstand R1 zum Steueranschluss G des jeweiligen Leistungshalbleiterschalters geführt.

Weiterhin ist die Leistungshalbleiterschaltung 2 derart ausgebildet, dass bei einem einzelnen der Leistungshalbleiterschalter T1, T2 und T3 eine zwischen dem ersten und zweiten Laststromanschluss C und E auftretende elektrische Leistungshalbleiterschalterspannung Us des betreffenden Leistungshalbleiterschalters überwacht wird. Solchermaßen wird bei einem einzelnen der elektrisch parallel geschalteten Leistungshalbleiterschalter die Leistungshalbleiterschalterspannung Us überwacht während bei allen übrigen elektrisch parallel geschalteten Leistungshalbleiterschalter die Leistungshalbleiterschalterspannung Us nicht überwacht wird. Beim Ausführungsbeispiel wird die Leistungshalbleiterschalterspannung Us des Leistungshalbleiterschalters T1 überwacht. Die Leistungshalbleiterschalterspannung Us wird dabei mittels einer Spannungsüberwachungseinheit 9 überwacht, wobei die Spannungsüberwachungseinheit 9 vorzugsweise Bestandteil der Ansteuereinheit 4 ist. Die Anschlusspunkte 11 und 12 der Zuleitungen der Spannungsüberwachungseinheit 9 bzw. der Ansteuereinheit 4 an denen die Leistungshalbleiterschalterspannung Us des Leistungshalbleiterschalters T1 zur Überwachung der Leistungshalbleiterschalterspannung Us abgegriffen wird, sind dabei in unmittelbarer Nähe des ersten und zweiten Laststromanschluss C und E des Leistungshalbleiterschalters T1 angeordnet, so dass die Leistungshalbleiterschalterspannung Us des Leistungshalbleiterschalters T1 von den Leistungshalbleiterschalterspannungen Us der übrigen elektrisch parallel geschalteten Leistungshalbleiterschaltern T2 und T3 durch die parasitären Induktivitäten Ls entkoppelt ist. Die Spannungsüberwachungseinheit 9 überwacht dabei vorzugsweise die Leistungshalbleiterschalterspannung Us auf Überschreitung eines Grenzwerts im eingeschalteten Zustand des Leistungshalbleiterschalters dessen Leistungshalbleiterschalterspannung Us überwacht wird und veranlasst eine Reaktion der Leistungshalbleiterschaltung falls der Grenzwert von der Leistungshalbleiterschalterspannung Us überschritten wird.

Es sei dabei an dieser Stelle angemerkt, dass im Sinne der Erfindung eine Überwachung der Leistungshalbleiterschalterspannung Us eine Reaktion der Leistungshalbleiterschaltung, falls das zu über überwachende Kriterium erfüllt ist, mit einschließt. Falls z.B. der oben beschriebene Grenzwert der Leistungshalbleiterschalterspannung Us im eingeschalteten Zustand des Leistungshalbleiterschalters überschritten wird aber keine Reaktion darauf von der Leistungshalbleiterschaltung erfolgt, so wird im Sinne der Erfindung die Leistungshalbleiterschalterspannung Us nicht überwacht.

Die Leistungshalbleiterschaltung 2 ist vorzugsweise derart ausgebildet, dass, falls im eingeschalteten Zustand des Leistungshalbleiterschalters dessen Leistungshalbleiterschalterspannung überwacht wird, die Leistungshalbleiterschalterspannung einen Grenzwert überschreitet, eine Ausschaltung aller elektrisch parallel geschalteten Leistungshalbleiterschalter durchgeführt wird. Die Überwachung auf Überschreitung des Grenzwerts wird dabei von der Spannungsüberwachungseinheit 9 durchgeführt, wobei die Ausschaltung aller elektrisch parallel geschalteten Leistungshalbleiterschalter, falls der Grenzwert im eingeschalteten Zustand des Leistungshalbleiterschalters dessen Leistungshalbleiterschalterspannung überwacht überschritten wird, vorzugsweise von der Ansteuereinheit 4 durchgeführt wird. Da bei einem Leistungshalbleiterschalter ein hoher durch den Leistungshalbleiterschalter vom ersten zum zweiten Laststromanschluss des Leistungshalbleiterschalter fließender elektrischer Strom im eingeschalteten Zustand des Leistungshalbleiterschalter zu einer hohen Leistungshalbleiterschalterspannung Us des Leistungshalbleiterschalters führt, kann somit eine sehr schnell arbeitende Überstromüberwachung der elektrisch parallel geschalteten Leistungshalbleiterschalter realisiert werden.

Aufgrund von Bauteiltoleranzen und unterschiedlicher parasitärer Induktivitäten der Zuleitungen zu den elektrisch parallel geschalteten Leistungshalbleiterschaltern kommt es häufig zu unterschiedlichen Ein- und Ausschaltzeitpunkten der elektrisch parallel geschalteten Leistungshalbleiterschalter. Die unterschiedlichen Ein- und Ausschaltzeitpunkte führen zu elektrischen Potentialverschiebungen an den zweiten Laststromanschlüssen der elektrisch parallel geschalteten Leistungshalbleiterschalter, so dass sich die elektrisch parallel geschalteten Leistungshalbleiterschalter gegenseitig in Ihrem Schaltverhalten beeinflussen, was zu einer ungleichmäßigen Stromaufteilung zwischen den elektrisch parallel geschalteten Leistungshalbleiterschaltern führt. Wenn z.B. im eingeschalteten Zustand des Leistungshalbleiterschalters T1 der Leistungshalbleiterschalter T2 eingeschaltet wird, dann nähert sich das elektrische Potential des Emitters E des Leistungshalbleiterschalters T2, dem elektrischen Potential des Kollektors K des Leistungshalbleiterschalter T2 an, so dass sich eine Potentialverschiebung des elektrischen Potentials des Emitters E des Leistungshalbleiterschalters T1 ergibt. Dies kann z.B. dazu führen, dass die zwischen dem Gate G und dem Emitter E des Leistungshalbleiterschalters T1 anliegende Spannung Ug nicht mehr hoch genug ist um den Leistungshalbleiterschalters T1 im eingeschalteten Zustand zu belassen, so dass der Leistungshalbleiterschalters T1 sich im Extremfall ganz ausschaltet oder aber in einen Zwischenzustand übergeht, bei dem der Durchlasswiderstand des Leistungshalbleiterschalters T1 erhöht ist. Das System kann dabei auch elektrisch zu schwingen anfangen.

Zur Lösung dieser Problematik ist es aus der EP 1625 660 B1 bekannt bei allen elektrisch parallel geschalteten Leistungshalbleiterschaltern zwischen der Ansteuereinheit, welche die elektrisch parallel geschalteten Leistungshalbleiterschalter ansteuert und den elektrisch parallel geschalteten Leistungshalbleiterschaltern jeweilig eine Gleichtaktdrossel vorzusehen, die in der EP 1625 660 B1 als Gleichtaktunterdrückungsdrossel bezeichnet wird. Die oben beschriebene Potentialverschiebung des elektrischen Potentials des Emitters des betreffenden Leistungshalbleiterschalters führt zu einem entsprechenden Spannungsabfall an der zwischen der Ansteuereinheit und dem zweiten Lastanschluss des betreffenden Leistungshalbleiterschalters elektrisch geschalteten zweiten Wicklung der jeweiligen Gleichtaktdrossel, die zu einer endsprechenden elektrischen Spannung an der elektrisch zwischen Ansteuereinheit und dem Steueranschluss des jeweiligen Leistungshalbleiterschalters geschalteten ersten Wicklung der jeweiligen Gleichtaktdrossel führt. Die längs der ersten und zweiten Wicklung auftretenden Spannungen heben sich somit im Ansteuerkreis auf, so dass die Potentialverschiebung des elektrischen Potentials des Emitters des betreffenden Leistungshalbleiterschalters auf die zwischen dem Gate und dem Emitter des betreffenden Leistungshalbleiterschalters anliegende Spannung keinen oder nur einen stark reduzierten Einfluss hat. Nachteilig bei der in der EP 1625 660 B1 vorgeschlagen Lösung ist, dass die oben beschriebene Überstromerkennung nicht mehr ordnungsgemäß funktioniert, da die an der zweiten Wicklung der jeweiligen Gleichtaktdrossel abfallende Spannung, eine scheinbar zu hohe Leistungshalbleiterschalterspannung zwischen Kollektor und Emitter des betreffenden Leistungshalbleiterschalters vortäuscht und somit einen Überstrom vortäuscht.

Bei der vorliegenden Erfindung ist elektrisch zwischen den Leistungshalbleiterschaltern, deren Leistungshalbleiterschalterspannung nicht überwacht wird und der Ansteuereinheit jeweilig eine Gleichtaktdrossel geschaltet oder falls die Leistungshalbleiterschaltung nur zwei Leistungshalbleiterschalter aufweist, ist elektrisch zwischen dem Leistungshalbleiterschalter, dessen Leistungshalbleiterschalterspannung nicht überwacht wird und der Ansteuereinheit, eine Gleichtaktdrossel geschaltet ist, wobei elektrisch zwischen dem Leistungshalbleiterschalter, dessen Leistungshalbleiterschalterspannung überwacht wird und der Ansteuereinheit keine Gleichtaktdrossel geschaltet ist.

Im Gegensatz zur der EP 1625 660 B1 wird bei der vorliegenden Erfindung somit gezielt bei einem einzelnen der Leistungshalbleiterschalter eine zwischen dem ersten und zweiten Laststromanschluss auftretende elektrische Leistungshalbleiterschalterspannung des betreffenden Leistungshalbleiterschalters überwacht und genau bei diesem Leitungshalbleiterschalter ist keine Gleichtaktdrossel zwischen Ansteuereinheit und betreffenden Leitungshalbleiterschalter elektrisch geschaltet, während bei allen übrigen elektrisch parallel geschalteten Leitungshalbleiterschaltern jeweilig elektrisch eine Gleichtaktdrossel zwischen Ansteuereinheit und den betreffenden Leitungshalbleiterschaltern geschaltet ist.

Beim Ausführungsbeispiels ist somit elektrisch zwischen den Leistungshalbleiterschaltern T2 und T3, deren Leistungshalbleiterschalterspannung Us nicht überwacht wird und der Ansteuereinheit 4, jeweilig eine Gleichtaktdrossel 10 geschaltet, und elektrisch zwischen dem Leistungshalbleiterschalter T1, dessen Leistungshalbleiterschalterspannung Us überwacht wird und der Ansteuereinheit 4 keine Gleichtaktdrossel geschaltet.

Die jeweilige Gleichtaktdrossel 10 weist eine erste Wicklung W1 und eine mit der ersten Wicklung W1 magnetisch gekoppelte zweite Wicklung W2 auf, wobei die erste Wicklung W1 elektrisch zwischen der Ansteuereinheit 4 und dem Steueranschluss G des jeweiligen Leistungshalbleiterschalters T2 bzw. T3 geschaltet ist und die zweite Wicklung W2 elektrisch zwischen der Ansteuereinheit 4 und dem zweiten Lastanschluss E des jeweiligen Leistungshalbleiterschalters T2 bzw. T3 geschaltet ist.

Da bei der Erfindung alle elektrisch parallel geschalteten Leistungshalbleiterschalter bis auf den Leistungshalbleiterschalter dessen Leistungshalbleiterschalterspannung überwacht wird mit einer jeweiligen Gleichtaktdrossel elektrisch verschaltet werden, wird implizit auch eine für den praktischen Betrieb ausreichende Entkopplung des Schaltverhaltens des Leistungshalbleiterschalters dessen Leistungshalbleiterschalterspannung überwacht wird von den übrigen elektrisch parallel geschalteten Leistungshalbleiterschalter erreicht.

Um das Auftreten von hohen Strömen durch die zweite Wicklung W2, der jeweiligen Gleichtaktdrossel 10 zu vermeiden, falls die jeweilige Gleichtaktdrossel 10 überlastet wird und in magnetische Sättigung geht, ist vorzugsweise elektrisch zwischen der Ansteuereinheit 4 und der jeweiligen Gleichtaktdrossel 10 ein zweiter elektrischer Widerstand R2 geschaltet.

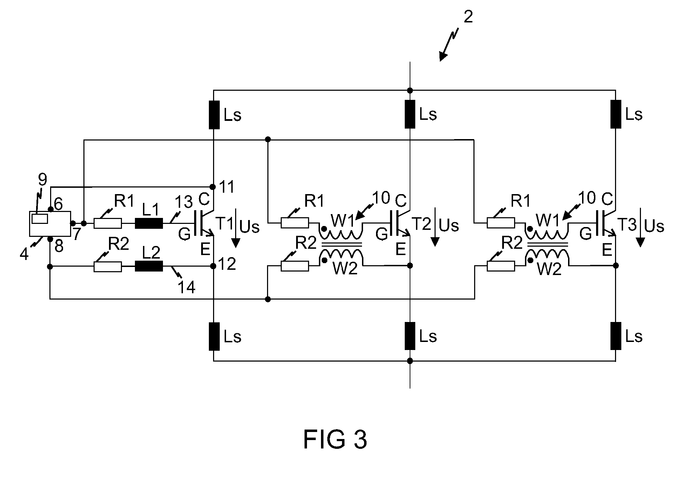

Da die erste und zweite Wicklung W1 und W2 der jeweiligen Gleichtaktdrossel 10 eine Streuinduktivität aufweisen, die Einfluss auf das Schaltverhalten des jeweiligen Leistungshalbleiterschalters vor dessen Steueranschluss sie elektrisch geschaltet ist, hat, ist vorzugweise wie in FIG 3 dargestellt, elektrisch zwischen der Ansteuereinheit 4 und dem Steueranschluss G des Leistungshalbleiterschalters T1, dessen Leistungshalbleiterschalterspannung Us überwacht wird, eine diskrete Spule L1 geschaltet oder ein magnetisch leitendes Element L1 umlaufend um eine elektrisch zwischen der Ansteuereinheit 4 und dem Steueranschluss G des Leistungshalbleiterschalters T1, dessen Leistungshalbleiterschalterspannung Us überwacht wird, geschaltete Leitung 13 angeordnet. Die Induktivität der diskreten Spule L1 oder des magnetisch leitenden Elements L1 entspricht dabei vorzugsweise im Wesentlichen der Summe der Streuinduktivitäten der ersten und zweiten Wicklung W1 und W2 der Gleichtaktdrossel 10 und insbesondere der Summe der Streuinduktivitäten der ersten und zweiten Wicklung W1 und W2 der Gleichtaktdrossel 10. Das magnetisch leitende Element L1 ist vorzugsweise als Ferritperle oder als Klappferrit ausgebildet.

Alternativ hierzu kann, wie in FIG 3 dargestellt, elektrisch auch zwischen der Ansteuereinheit 4 und dem zweiten Lastanschluss E des Leistungshalbleiterschalters T1, dessen Leistungshalbleiterschalterspannung Us überwacht wird, eine diskrete Spule L2 geschaltet sein oder ein magnetisch leitendes Element L2 umlaufend um eine elektrisch zwischen der Ansteuereinheit 4 und dem zweiten Laststromanschluss E des Leistungshalbleiterschalters T1, dessen Leistungshalbleiterschalterspannung Us überwacht wird, geschaltete Leitung 14 angeordnet sein. Die Induktivität der diskreten Spule L2 oder des magnetisch leitenden Elements L2 entspricht dabei vorzugsweise im Wesentlichen der Summe der Streuinduktivitäten der ersten und zweiten Wicklung W1 und W2 der Gleichtaktdrossel 10 und insbesondere der Summe der Streuinduktivitäten der ersten und zweiten Wicklung W1 und W2 der Gleichtaktdrossel 10. Das magnetisch leitende Element L2 ist vorzugsweise als Ferritperle oder als Klappferrit ausgebildet.

Alternativ hierzu kann elektrisch auch zwischen der Ansteuereinheit 4 und dem Steueranschluss G des Leistungshalbleiterschalters T1, dessen Leistungshalbleiterschalterspannung Us überwacht wird, eine diskrete Spule L1 geschaltet oder ein magnetisch leitendes Element L1 umlaufend um die elektrisch zwischen der Ansteuereinheit 4 und dem Steueranschluss G des Leistungshalbleiterschalters T1, dessen Leistungshalbleiterschalterspannung Us überwacht wird, geschaltete Leitung 13 angeordnet sein und elektrisch zwischen der Ansteuereinheit 4 und dem zweiten Lastanschluss E des Leistungshalbleiterschalter T1, dessen Leistungshalbleiterschalterspannung Us überwacht wird, eine diskrete Spule L2 geschaltet sein oder ein magnetisch leitendes Element L2 umlaufend um eine elektrisch zwischen der Ansteuereinheit 4 und dem zweiten Laststromanschluss E des Leistungshalbleiterschalters T1, dessen Leistungshalbleiterschalterspannung Us überwacht wird, geschaltete Leitung 14 angeordnet sein. Die Induktivität der diskreten Spule L1 oder des magnetisch leitenden Elements L1 entspricht dabei vorzugsweise im Wesentlichen der Streuinduktivität der ersten Wicklung W1 der Gleichtaktdrossel 10 und insbesondere der Streuinduktivität der ersten Wicklung W1 der Gleichtaktdrossel 10. Die Induktivität der diskreten Spule L2 oder des magnetisch leitenden Elements L2 entspricht dabei vorzugsweise im Wesentlichen der Streuinduktivität der zweiten Wicklung W2 der Gleichtaktdrossel 10 und insbesondere der Streuinduktivität der zweiten Wicklung W2 der Gleichtaktdrossel 10. Das jeweilige magnetisch leitende Element L2 ist vorzugsweise als Ferritperle oder als Klappferrit ausgebildet.

Die Schaltverhalten des Leistungshalbleiterschalters, dessen Leistungshalbleiterschalterspannung überwacht wird kann durch diese Maßnahme an das Schaltverhalten der übrigen elektrisch parallel geschalteten Leistungshalbleiterschalter angepasst werden.

Es sei an dieser Stelle angermerkt, dass in FIG 3 die diskrete Spule L2 bzw. das magnetisch leitende Elements L2 als schwarzes Rechteck symbolisiert ist.

Es sei weiterhin angemerkt, dass unter dem Ausdruck "magnetisch gekoppelte" im Sinne der Erfindung eine mittels eines magnetisch leitfähigen Kerns, wie z.B. einem Eisenkern oder Ferritkern, bestehende magnetische Kopplung zwischen Wicklungen verstanden wird. Die magnetisch gekoppelten Wicklungen sind hierzu um den magnetisch leitfähigen Kern gewickelt.

Ferner sei angemerkt, dass unter dem Ausdruck "diskrete Spule" im Sinne der Erfindung eine mit einem magnetisch leitfähigen Kern versehende Spule oder eine nicht mit einem magnetisch leitfähigen Kern versehende Spule, wobei die Spule nicht magnetisch mit einer weiteren Spule, welche elektrisch in einen anderen elektrischen Zweig wie die Spule geschaltet ist, gekoppelt ist, verstanden wird. Eine eventuell physikalisch vorhandene schwache magnetische Kopplung über das magnetische Streufeld der Spule mit der weiteren Spule wird im Sinne der Erfindung nicht als magnetische Kopplung angesehen.

## Patentansprüche

1. Leistungshalbleiterschaltung aufweisend,
• mehrere elektrisch parallel geschaltete Leistungshalbleiterschalter (T1,T2,T3), die jeweilig einen ersten und einen zweiten Laststromanschluss (C,E) und einen Steueranschluss (G) aufweisen, wobei die ersten Laststromanschlüsse (C) der Leistungshalbleiterschalter (T1,T2,T3) elektrisch leitend miteinander verbunden sind und die zweiten Laststromanschlüsse der Leistungshalbleiterschalter (T1,T2,T3) elektrisch leitend miteinander verbunden sind, wobei die Leistungshalbleiterschaltung derart ausgebildet ist, dass bei einem einzelnen (T1) der Leistungshalbleiterschalter (T1,T2,T3) eine zwischen dem ersten und zweiten Laststromanschluss (C,E) auftretende elektrische Leistungshalbleiterschalterspannung (Us) des betreffenden Leistungshalbleiterschalters (T1) überwacht wird und
• eine Ansteuereinheit (4), die zur Erzeugung eines Ansteuersignals zur Ansteuerung der Leistungshalbleiterschalter (T1,T2,T3) ausgebildet ist, wobei die Ansteuereinheit (4) mit den Steueranschlüssen (G) der Leistungshalbleiterschalter (T1,T2,T3) und mit den zweiten Laststromanschlüssen (E) der Leistungshalbleiterschalter (T1,T2,T3) elektrisch verbunden ist,
wobei elektrisch zwischen den Leistungshalbleiterschaltern (T2,T3), deren Leistungshalbleiterschalterspannung (Us) nicht überwacht wird und der Ansteuereinheit (4) jeweilig eine Gleichtaktdrossel (10) geschaltet ist oder falls die Leistungshalbleiterschaltung nur zwei Leistungshalbleiterschalter (T1,T2) aufweist, elektrisch zwischen dem Leistungshalbleiterschalter (T2), dessen Leistungshalbleiterschalterspannung (Us) nicht überwacht wird und der Ansteuereinheit (4), eine Gleichtaktdrossel (10) geschaltet ist,
wobei elektrisch zwischen dem Leistungshalbleiterschalter (T1), dessen Leistungshalbleiterschalterspannung (Us) überwacht wird und der Ansteuereinheit (4) keine Gleichtaktdrossel (10) geschaltet ist,
wobei die jeweilige Gleichtaktdrossel (10) eine erste Wicklung (W1) und eine mit der ersten Wicklung (W1) magnetisch gekoppelte zweite Wicklung (W2) aufweist, wobei die erste Wicklung (W1) elektrisch zwischen der Ansteuereinheit (4) und dem Steueranschluss (G) des jeweiligen Leistungshalbleiterschalters (T2,T3) geschaltet ist und die zweite Wicklung (W2) elektrisch zwischen der Ansteuereinheit (4) und dem zweiten Lastanschluss (E) des jeweiligen Leistungshalbleiterschalters (T2,T3) geschaltet ist.

2. Leistungshalbleiterschaltung nach Anspruch 1, **dadurch gekennzeichnet, dass** elektrisch zwischen der Ansteuereinheit (4) und dem Steueranschluss (G) des Leistungshalbleiterschalters (T1), dessen Leistungshalbleiterschalterspannung (Us) überwacht wird, eine diskrete Spule (L1) geschaltet ist oder ein magnetisch leitendes Element (L1) umlaufend um eine elektrisch zwischen der Ansteuereinheit (4) und dem Steueranschluss (G) des Leistungshalbleiterschalters (T1), dessen Leistungshalbleiterschalterspannung (Us) überwacht wird, geschaltete Leitung (13) angeordnet ist.

3. Leistungshalbleiterschaltung nach Anspruch 1 oder 2, **dadurch gekennzeichnet, dass** elektrisch zwischen der Ansteuereinheit (4) und dem zweiten Lastanschluss (E) des Leistungshalbleiterschalters (T1), dessen Leistungshalbleiterschalterspannung (Us) überwacht wird, eine diskrete Spule (L2) geschaltet ist oder ein magnetisch leitendes Element (L2) umlaufend um eine elektrisch zwischen der Ansteuereinheit (4) und dem zweiten Laststromanschluss (E) des Leistungshalbleiterschalters (T1), dessen Leistungshalbleiterschalterspannung (Us) überwacht wird, geschaltete Leitung (14) angeordnet ist.

4. Leistungshalbleiterschaltung nach Anspruch 2 oder 3, **dadurch gekennzeichnet, dass** das magnetisch leitende Element (L1,L2) als Ferritperle oder als Klappferrit ausgebildet ist.

5. Leistungshalbleiterschaltung nach einem der vorhergehenden Ansprüche, **dadurch gekennzeichnet, dass** die Leistungshalbleiterschaltung (2) derart ausgebildet ist, dass falls im eingeschalteten Zustand des Leistungshalbleiterschalters (T1) dessen Leistungshalbleiterschalterspannung (Us) überwacht wird, die Leistungshalbleiterschalterspannung (Us) einen Grenzwert überschreitet, eine Ausschaltung aller elektrisch parallel geschalteten Leistungshalbleiterschalter (T1,T2,T3) durchgeführt wird.
